# EUROPEAN PATENT SPECIFICATION

(11) **EP 0 233 125 B1**
(45) Date of publication and mention of the grant of the patent: **06.10.1993**
(21) Application number: 87400314.8
(22) Date of filing: 12.02.1987
(51) Int. Cl.: H05K 13/04, H05K 3/34

(54) **Surface mount technology repair station and method for repair of surface mount technology circuit boards**
Reparaturvorrichtung und Reparaturverfahren für Leiterplatten mit Bauteilen in Oberflächenmontagetechnologie
Station et méthode de réparation des plaques de câblage à composants de la technologie de montage en surface

(30) Priority: 13.02.1986 US 829445
(43) Date of publication of application: 19.08.1987
(73) Proprietor: DIGITAL EQUIPMENT CORPORATION, Maynard, MA 01754 (US)
(72) Inventor: Kolesar, Michael J., Derry New Hampshire 03038 (US); Bois, Philip J., Manchester New Hampshire 03104 (US)
(74) Representative: Mongrédien, André

(56) References cited:
- EP-A- 0 106 564
- EP-A- 0 214 030
- FR-A- 2 573 950
- GB-A- 2 149 708
- US-A- 4 136 444
- TECHNICAL DIGEST WESTERN ELECTRIC, no. 75, September 1984, page 11; C. COLDERWOOD:"Hot air device for desoldering IC chip from PCB"

## Description

Reference is made to the EP-A-0 214 030, invented by Michael J. Kolesar, entitled "Surface Mount Technology Automated Repair System", the disclosure of which is incorporated herein by reference.

This invention relates generally to an apparatus and method for the repair of printed circuit board having surface-mounted components positioned thereon. In this invention the equipment for assembling a plurality of electronic components (42) on a circuit board (50) including means (26A.26B.28.30) for manipulating the components relative to the board and processor means for controlling the manipulating means in a predetermined sequence to effect assembly of the components on the board repair apparatus for removing faulty components from boards after assembly comprises :
- a source of heat ;
- means (72) for applying heat from said heat source to a faulty component to be removed from a board said heat applying means being carried by and movable with the component manipulating means (26A.26B.28.30) and
- means for enabling the processor means selectively to activate said heat source said heat applying means and the component manipulating means in a predetermined repair sequence to remove said faulty component from said board.

The EP-A-0 214 030 falls under Article 54(3) EPC and does not teach the use of the two heaters as recited in the independent claims. Rather, that patent application discloses a technique suitable for automation for de-soldering using hot air applied to a component on a circuit board. This reference is mentioned in the present application as being a related case. The present invention is an improvement over the invention disclosed in that application.

### Background of the Invention

Electronic circuit assemblies which include a plurality of different electronic components mounted together on modules, often called a circuit boards, are common in computer and other electronic equipment. The boards are usually formed of a fiberglass-filled composition. Each of the electronic components on a board has leads which are electrically interconnected to leads on other components by conductors directly formed on the board.

In conventional assemblies of this type, the electronic components are mounted on one surface of the board, and the leads of the components pass through plated holes to the opposite surface of the board where they are soldered, to thereby secure the components to the board, as well as make the required electrical connections. Surface mount technology (SMT) boards differ from conventional boards in that the component leads are soldered to conductive "pads" disposed on the surface to which the particular component is to be mounted. The leads, therefore, need not, and generally do not, pass through holes to the opposite surface of the board. This surface-mount technology is finding increasing usage in the manufacture of circuit board assemblies, because it has marked advantages over prior conventional technology. Specifically, the procedures for producing SMT board assemblies are generally simpler and more economical than the procedures to fabricate conventional board assemblies.

Further, SMT board assemblies permit reductions in the sizings of the individual components mounted on the boards and reductions in the sizes of the boards as well. They also permit the unrestricted mounting of components on both surfaces of the boards, thus providing denser assemblies, i.e. with increased circuitry disposed in less space.

Technical Digest. Western Electric no. 75, September 1984, page 11, discloses a device for desoldering an IC chip from a printed circuit board, wherein hot air is directed as a first stream to the top of a chip mounted on a board and a second, hotter, stream of hot air is directed onto the leads at the underside of the board.

In a typical SMT board repair apparatus, a component to be removed is heated by a hand-held hot air blower to a temperature such that the solder, which joins the leads of the component to the SMT board at solder pads on the board, melts. The component is then removed. In like fashion, components are added to SMT board assemblies by placing the leads, which have a solder paste applied thereto, on the pads of the SMT board and then applying a directed hot air flow over the component and the leads such that the solder paste is liquidified. Renewal of the heat source then permits the solder to solidify and thereby secure the component to the board.

An alternative repair method involves the use of a hand-held soldering iron, which functions much like a pair of tweezers. The tips of the iron, when squeezed together, have a shape matching the perimeter of the component to be removed from the SMT board. The tips of the iron are positioned on the leads of the component to be removed and the iron is heated until the operator observes the solder melting sufficiently to permit the component to be removed from the board. For installing components on the SMT board, this procedure is reversed.

Both of the above-referenced methods of repair are slow and tedious, and require a significant amount of manual dexterity in their applications. The application of heat necessary to melt the solder can result in damage to the SMT board itself, and the conductors found thereon, in the form of buckling or even delamination. The use of hot air circulation over the board also causes, in some instances, electrostatic discharge damage to components positioned on the board, due to the presence of ions in the heated air.

In light of the above, it is an object of this invention to provide an improved apparatus and method for the repair of surface-mount-technology circuit board assemblies. Another object of this invention is to provide an SMT circuit board repair apparatus which is semi-automatic and requires little operator training and only routine operator involvement.

Still another object of the invention is to provide an SMT circuit board repair apparatus and method which minimizes the likelihood of damage to the board and to the components on the board.

Other objects will be specified in or obvious from the detailed description of the illustrated embodiments of the invention which follows.

### Summary of the Invention

A repair station of the present invention is defined in independent Claims 1 and 8. According to an embodiment of the present invention, a surface-mount-technology repair station for replacing components on SMT circuit boards includes a base with a controllable heating element through which deionized air is blown onto the surface of a board opposite to the surface on which the repair is to be effected. This raises the temperature of the entire board substantially but to a point below the melting point of solder. A second heating element through which deionized air is blown is positioned over the leads of a selected component positioned on the board, that is either to be removed from or secured to the board. The heating of the leads by the second heating element causes the solder on these leads to melt, thus, enabling replacement of the component. To remove the component, the operator, using an instrument, such as tweezers, grasps the component and removes it from the board. To install a component, the operator, after melting solder on the leads, discontinues the heating of the component.

Because of the elevated temperature of the entire board, there is a lesser temperature differential between the portions where soldering or desoldering is taking place and other portions of the board, than in prior methods. This lesser differential prevents the delamination and related damage that would otherwise result from differential thermal expansion. Also, deionization of the air that is used to supply heat to the board materially reduces the occurrence of damage due to electrostatic discharge.

The method of the present invention is defined in Claim 10. It includes the steps of heating the surface-mount-technology boards to a substantially high temperature, and heating the leads of a selected component to be replaced so that the solder disposed on the leads melts. The method can further include directing deionized air over the board and components thereon.

### Brief Description of the Drawings

The foregoing objects, features, and advantages of the invention will be better understood from the following detailed description taken with the accompanying drawings in which:
FIG. 1 is a perspective view of the SMT repair station in accordance with the present invention;
FIG. 2 is an enlarged, cutaway view of the transverse arm, with an upper housing thereon, of the SMT repair station of FIG. 1;
FIG. 2A is an enlarged view of an orifice plate, positionable in the upper housing of FIG. 2; and
FIG. 3 is a partly schematic view of the SMT repair station of FIG. 1.

### Detailed Description of the Preferred Embodiments

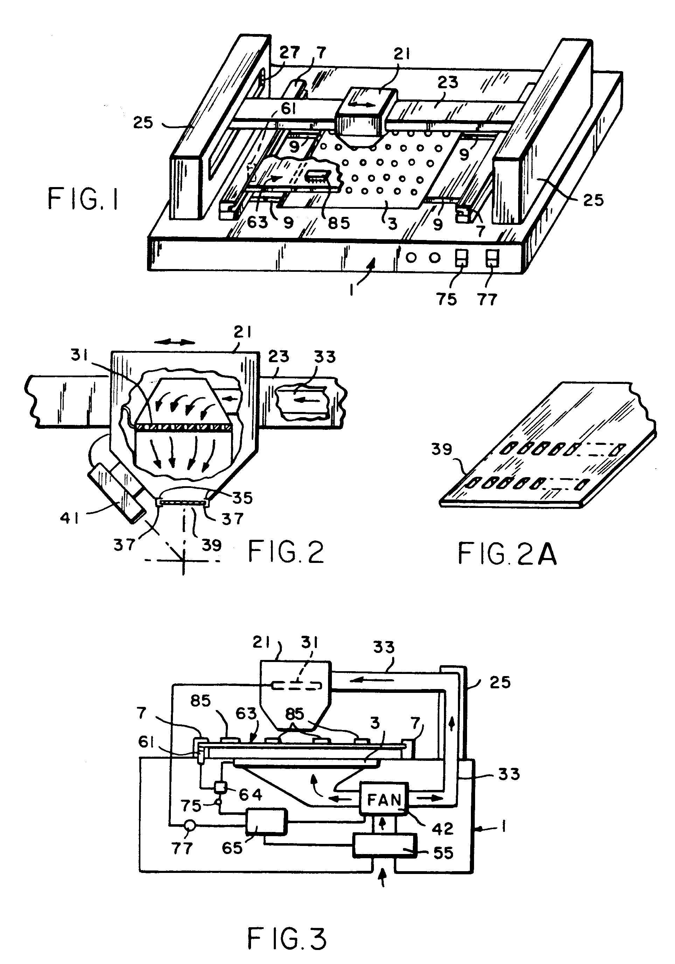

With reference to FIG. 1, an surface-mount-technology repair station embodying the present invention has a base 1 with a perforated infrared panel 3 disposed therein. Module holding fixtures 7 supporting an SMT circuit board 63, are positioned on the base 1 and are slidable in elongated slots 9 in the base.

An upper housing 21 is slidably positioned on a transverse rod 23. The rod 23 is supported for movement perpendicular to its longitudinal axis by mounting blocks 25. Specifically, each of the blocks 25 has an aperture 27 for receiving and supporting an end of the transverse rod 23. Thus, the housing 21 and rod 23 can be easily displaced to bring the housing over any desired location on the circuit board 63.

With reference to FIG. 2, an infrared panel 31 having apertures therein, is mounted in the upper housing 21. A flexible, extendable air line 33 extends through a mounting block 25 and the transverse rod 23 so that air blown through the air line 33 passes through the apertures in the panel 31. The housing 21 is provided with a mounting receptacle 35, which has two elongated U-shaped members 37, sized to receive interchangeable orifice plates, such as the orifice plate seen at 39 (See FIG. 2A). Manual location of the housing 21 with respect to the circuit board 63 is facilitated by a high intensity light source 41 which is carried by the housing 21 and aims a light at the point on the board 63 directly beneath the center of the aperture plate 39.

Referring now to FIG. 3, a fan 42 draws air from the atmosphere through the base 1 and the air is directed through apertures in the infrared panels 3 and 31 via an air line 43 and the air line 33, respectively. The lower surface of the board 63 is thus heated by panel 3, both by infrared energy transmission and the air heated by passage through the panel 3. The portions of the upper surface of the board beneath the apertures in the plate 39 (FIG. 2a) are heated by the panel 31, both by infrared energy transmitted and by air flow through the plate 39. Air entering the base 1 is drawn by the fan 42 through a deionizing chamber 55, which deionizes the air passing therethrough in a known manner.

As also shown in FIG. 3, a thermocouple 61 is positioned in one of the mounting fixtures 7 so as to contact the board 63. A controller unit 64, to which the thermocouple 61 is connected, operates to control the heat supplied by infrared panel 3 to the board 63 so as to maintain the panel at an elevated temperature, as discussed below. Electric current is provided to heat the infrared panel 3 from a source external to the unit through a transformer 65. A manual on-off switch 75 provides operator control for the infrared panel 3, and likewise, a switch 77 provides operator control for the infrared panel 31.

The use and function of the above-described unit are as follows: A module, such as the circuit board 63, having surface mounted components, such as integrated circuit chips 85, positioned thereon, is positioned in the movable fixtures 7. The board 63 is heated from underneath by the infrared panel 3. The temperature to which the board 63 is preferably heated to a substantially elevated temperature such that the board has reached its thermal expansion limit over the relevant temperature range. In the case of a board formed of a composition not having such a thermal expansion limit, the board is heated to a substantially elevated temperature, such that the thermal thermal expansion, resulting from the melting of the solder in the leads of the selected component to be replaced, is minimal. This elevated temperature, in any event, should be below the melting temperature of the solder used to secure the components to the board.

The board 63 is, thus, for ordinary fiberglass boards usually heated to a temperature approximately between 141°C (285°F) and 149°C (300°F), which is above the "glass transition" temperature of the board, such that only minimal thermal expansion of the board 63 results from the melting of the solder on the leads of the selected component to be replaced. The operator of the repair assembly inserts into the brackets 37 an orifice plate, such as the plate 39, which has apertures corresponding with the leads of a selected component 85 to be removed. The orifice plates, preferably, should be formed of material, such as aluminum, that will not deform from repeated heatings.

The upper housing 21 is then positioned by the operator above the selected component 85 to be removed. The high intensity light assists the operator in this task. The upper infrared panel 31 is heated and deionized air is blown through the apertures in the panel. The radiant energy of the panel 31 and the deionized air is directed by the orifice plate 39 to the leads of the component 85. Upon the melting of the solder, usually at a temperature of approximately 260°C (500°F), the component 85 is thereby removable from the board 63.

The installation of components is essentially the same. After positioning and heating the board 63, the component 85 to be installed, having solder paste disposed on its leads, is positioned with its leads on soldering pads positioned on the board 63. The operator inserts in the brackets 37 an orifice plate 39, having apertures which correspond with the leads of the component 85. The upper housing 21 is aligned by the operator over the component with the reference beam of the high intensity light 41. The infrared panel 31 is then turned on, and deionized air is blown through the orifice plate 39 to the leads of the component 85. Upon the liquifaction of the solder paste, the heating is stopped so that the component is secured to the board by the subsequent solidification of the solder.

It will be recognized and understood that the present invention minimizes damage to SMT circuit boards and the components positioned thereon. The heating of the entire board reduces the likelihood of damage to the board such as possible delamination or buckling resulting from uneven heating. The directing of deionized air over the board and components thereon, also reduces the likelihood of electrostatic discharge damage to the components disposed on the board. The present invention also simplifies manual tasks to be performed by the operators of the device, as compared with those devices of the prior art.

## Claims

1. A repair station for replacing selected components (85) on circuit boards (63), said repair station comprising:
A) a base (1) having fixture means (7) for removably mounting a SMT circuit board;
C) first heating means (3, 42) disposed in said base (1) to heat said entire circuit board (63) to a substantially elevated, first temperature below that which is capable of melting solder on a plurality of leads of said selected component;
D) second heating means (31, 33, 39, 42) to heat the leads of a selected component (85) on said circuit board (63) to a second temperature that is higher than said first temperature, and capable of melting solder on said leads of said selected component to enable the replacement of said component; and
E) means connected to said base (1) for mounting said second heating means;
F) whereby a lesser temperature differential may be established during heating between the portions of said circuit board where soldering or de-soldering is taking place and other portions of said circuit board, thereby reducing damage from diffential thermal expansion.

2. The repair station according to claim 1, wherein said mounting means comprises:
A) a transverse rod (23) having a longitudinal axis and supported on each end by said base (1), such that said rod is movable in a direction perpendicular to said longitudinal axis; and
B) a housing (21) carrying said second heating means (31 or 39) and mounted for slidable movement along said rod (23), whereby positioning of said second heating means relative to said selected component (85) is accomplished by movement of said rod (23) and said housing (21).

3. The repair station according to claim 1 or 2, wherein said first and second heating means include respective first and second infrared heating panels (3, 31) for directing infrared energy to said circuit board (63), and said first infrared panel (3) is substantially larger than said second infrared panel (31).

4. The repair station according to claim 3, wherein said first and second infrared panels (3, 31) have apertures for directing deionized air to said circuit board (63), and said repair station further comprises means (33, 42, 43) for directing deionized air to said infrared panels (3, 31).

5. The repair station according to claim 1 or 2, wherein said first heating means includes a first apertured infrared panel (3) for heating a first side of said circuit board (63), and said second heating means includes a second apertured infrared panel (31), and said first panel is substantially larger than said second panel (63); the repair station further comprising a removable orifice plate (39) positioned at the orifice of said housing means (42, 43) for blowing air through said apertures in said first panel for heating said circuit board, and means (42, 33, 39) for blowing air through said second panel and orifice plate for heating said leads of said selected component.

6. The repair station according to claim 1 or 2, further comprising a thermocouple (61) positioned in the fixture means (7) for contacting said circuit board (63); and means (61, 64) coupled to said thermocouple for controlling the temperature to which the circuit board is heated by said heating means.

7. The repair station according to claim 1, further comprising:
A) a transverse rod (23) having a longitudinal axis and supported on each end by said base (1), such that said rod is movable in a direction perpendicular to said longitudinal axis;
B) a fan (42) disposed in said base;
C) said fixture means (7) supporting said circuit board between said base and said rod;
D) a housing (21) slideably positioned on said rod;
E) an infrared heating panel (31) having apertures therein and mounted in said housing; and
F) an air path (33) from said fan to said infrared heating panel for directing air from said fan through said apertures in said panel and to said circuit board, whereby said selected component can be heated by infrared energy from said heating panel and by air heated by said heating panel for liquefying solder on the leads of said selected component.

8. A repair station for replacing selected components on SMT circuit boards (63), said components (85) having leads soldered to said circuit board, said repair station comprising:
A) a base (1) with a controllable heating element (3);
B) a transverse rod (23) having a longitudinal axis and supported on each end by said base (1, 25), such that said rod is movable in a direction perpendicular to said longitudinal axis;
C) a fan (42) disposed in said base;
D) mounting fixtures (7) secured to said base for removably supporting said circuit board between said base and said rod;
E) a housing (21) slideably positioned on said rod;
F) an infrared heating panel (31) having apertures therein and mounted in said housing; and
G) an air path (33) from said fan to said controllable heating element (3) and said infrared heating panel, such that air is directed by said fan through said apertures in said panel and through said heating element (3).

9. The repair station in accordance with claim 8, wherein said controllable heating element (3) is infrared panel (3) having apertures therein, and mounted in said base and between said mounting fixtures; and
B) an air path (43) from said fan to said lower panel, such that air is directed by said fan through said apertures in said panel, whereby, when a board is disposed in said fixtures, said board is heated by said lower panel.

10. A method of replacing selected components on a SMT circuit board using a circuit board repair station, said method comprising the steps of:
A) removably securing a circuit board (63) in a mounting fixture (7) on a circuit board repair station;
B) heating said circuit board (63) and components thereon by a first heating means (3) to a substantially elevated, pre-selected first temperature that is below the melting point of solder joining the leads or said components to said circuit board (63); and
C) heating the leads of a selected component-to-be-replaced by a second heating means (31) to a pro-selected, second temperature that is above the melting temperature of the solder disposed on the leads of said selected component, whereby the selected component can be replaced.

11. The method in accordance with claim 10, wherein
A) said circuit-board-heating step includes activating an infrared panel (3), and directing deionizing air through said panel and to said circuit board, whereby the entire circuit board is maintained at or near said first temperature; and
B) said leads-heating step includes activating said second heating means (31), directing deionized air through the activated heating means to thereby elevate the temperature of the air, and directing the air to the leads of the selected components.

12. The method in accordance with claim 10 or 11
A) further including the step of positioning said second heating means (31) relative to a selected component (63) on said circuit board by sliding a housing (21) containing said second heating means along a transverse rod (23) on which said housing is positioned and moving said rod having a longitudinal axis and supported on each end by said base (1,25) direction perpendicular to said longitudinal axis.

13. The method in accordance with claims 10, wherein said first temperature is above the glass transition temperature of the circuit board.

14. The method in accordance with claim 10, further comprising the steps of
A) disposing solder paste on the leads of a selected replacement component (85);
B) positioning the replacement component (85) on said circuit board (85); and
C) discontinuing the heating by said second heating means after the solder paste melts, whereby the solder solidifies and said component is secured to said circuit board.

15. The method in accordance with claim 10, further comprising the steps of
A) discontinuing heating by said second heating means (31) after the solder melts; and
B) removing the selected component from the circuit board.

16. The method in accordance with claim 10, further comprising the steps of:
A) discontinuing the heating of the leads;
B) removing the selected component (85);
C) positioning a new component (85) with solder paste on the leads on said circuit board;
D) heating the leads of the new component to melt the solder paste;
E) discontinuing the heating of the leads and said circuit board (63); and
F) removing said circuit board from said repair station.

17. The method in accordance with claim 16, further comprising the steps of:
A) monitoring the temperature of the temperature of the circuit board;
B) controlling the first heating element (3) to maintain the circuit board at the elevated temperature of between 285°F (141⁰C) and 300°F (149°C).

## Patentansprüche

1. Reparaturvorrichtung zum Auswechseln ausgewählter Bauelemente (85) auf Leiterplatten (63), wobei die Reparaturvorrichtung umfaßt:
A) eine Basis (1), die Befestigungsmittel zur auswechselbaren Montage einer SMT-Leiterplatte aufweist,
C) erste Heizmittel (3, 42), die in der Basis angeordnet sind, zum Erhitzen der gesamten Leiterplatte (63) auf eine beträchtlich angehobene erste Temperatur unterhalb derjenigen, die zum Schmelzen von Lot einer Mehrzahl von Anschlußleitungen des ausgewählten Bauelements geeignet ist,
D) zweite Heizmittel (31, 33, 39, 42) zum Erhitzen der Anschlußleitungen eines ausgewählten Bauelements (85) auf der Leiterplatte (63) auf eine zweite Temperatur, die höher als die erste Temperatur ist und zum Aufschmelzen des Lots auf den Anschlußleitungen des Bauelements geeignet ist, um das Auswechseln des Bauelementes zu ermöglichen und
E) Mittel zum Anbau der zweiten Heizmittel, die mit der Basis (1) verbunden sind,
F) wodurch während des Aufheizens eine geringere Temperatur-differenz zwischen den Bereichen der Leiterplatte, an denen das Verlöten oder Entlöten stattfindet, und den anderen Bereichen der Leiterplatte eingestellt werden kann, wodurch die Beschädigung aufgrund unterschiedlicher thermischer Ausdehnung vermindert wird.

2. Reparaturvorrichtung gemäß Anspruch 1, wobei die Montagemittel umfassen:
A) einen Querstab (23), der eine Längsachse aufweist und an jedem Ende durch die Basis (1) so gestützt wird, daß der Stab in einer Richtung rechtwinklig zur Längsachse bewegbar ist und
B) ein Gehäuse (21), das die zweiten Heizmittel (31 oder 39) trägt und für eine verschiebbare Bewegung entlang des Stabes (23) montiert ist, wodurch ein Positionieren der zweiten Heizmittel relativ zum ausgewählten Bauelement (85) durch die Bewegung des Stabes (23) und des Gehäuses (21) ausgeführt wird.

3. Reparaturvorrichtung gemäß Anspruch 1 oder 2, wobei die ersten und zweiten Heizmittel entsprechende erste und zweite Infrarot-Heizfelder (3, 31) zum Hinlenken von Infrarotenergie auf die Leiterplatte (63) einschließen und wobei das erste Infrarotfeld (3) beträchtlich größer als das zweite Infrarotfeld (31) ist.

4. Reparaturvorrichtung gemäß Anspruch 3, wobei das erste und zweite Infrarotfeld (3, 31) Öffnungen zum Leiten von deionisierter Luft auf die Leiterplatte (63) aufweist und wobei die Reparaturvorrichtung (63) weiterhin Mittel (33, 42, 43) zum Leiten von deionisierter Luft zu den Infrarotfeldern (3, 31) umfaßt.

5. Reparaturvorrichtung gemäß Anspruch 1 oder 2, wobei das erste Heizmittel ein erstes mit Öffnungen versehenes Infrarotfeld (3) zum Heizen einer ersten Seite der Leiterplatte (63) einschließt und das zweite Heizmittel ein zweites mit Öffnungen versehenes Infrarotfeld (31) einschließt und das erste Feld beträchtlich größer als das zweite Feld ist, wobei die Reparaturvorrichtung weiterhin umfaßt, eine entfernbare Mündungsplatte (39), die an der Mündung des Gehäuses positioniert ist, Mittel (42, 43) zum Blasen von Luft durch die Öffnungen in dem ersten Feld zum Erhitzen der Leiterplatte und Mittel (42, 33, 39) zum Blasen von Luft durch das zweite Feld und die Mündungsplatte zum Erhitzen der Anschlußleitungen des ausgewählten Bauelements.

6. Reparaturvorrichtung gemäß Anspruch 1 oder 2, weiterhin umfassend: ein Thermoelement (61), das in den Befestigungsmitteln (7) zum Berühren der Leiterplatte angeordnet ist und Mittel (61, 64), die mit dem Thermoelement zum Regeln der Temperatur auf die die Leiterplatte durch die Heizmittel erhitzt wird, verbunden sind.

7. Reparaturvorrichtung gemäß Anspruch 1, weiterhin umfassend:
A) einen Querstab (23), der eine Längsachse aufweist und an jedem Ende durch die Basis (1) so gestützt wird, daß der Stab in einer Richtung rechtwinklig zur Längsachse bewegbar ist,
B) ein Gebläse (42), das in der Basis angeordnet ist,
C) wobei die Befestigungsmittel (7) die Leiterplatte zwischen der Basis und dem Stab stützen,
D) ein Gehäuse (21), das auf dem Stab verschiebbar angeordnet ist,
E) ein Infrarotheizfeld (31), das Öffnungen aufweist und in dem Gehäuse montiert ist und
F) einen Luftkanal (33) von dem Gebläse zu dem Infrarotheizfeld, um die Luft von dem Gebläse durch die Öffnungen in dem Feld und auf die Leiterplatte zu leiten, wodurch das ausgewählte Bauelement durch Infrarotenergie des Heizfeldes und durch vom Heizfeld aufgeheizte Luft zum Verflüssigen des Lots auf den Anschlußleitungen des ausgewählten Bauelements aufgeheizt werden kann.

8. Reparaturvorrichtung zum Auswechseln ausgewählter Bauelemente auf SMT-Leiterplatten (63), wobei die Bauelemente (85) Anschlußleitungen , die an die Leiterplatte gelötet sind, aufweisen und die Reparaturvorrichtung umfaßt:
A) eine Basis (1) mit einem regelbaren Heizelement (3),
B) einen Querstab (23), der eine Längsachse aufweist und an jedem Ende durch die Basis (1, 25) so gestützt wird, daß der Stab in einer Richtung rechtwinklig zu der Längsachse bewegbar ist,
C) ein Gebläse (42), das in der Basis (1) angeordnet ist,
D) Befestigungsmittel (7), die an der Basis zum auswechselbaren Stützen der Leiterplatte zwischen der Basis und dem Stab befestigt sind ,
E) ein Gehäuse (21), das auf dem Stab verschiebbar angeordnet ist,
F) ein Infrarotheizfeld (31), das Öffnungen aufweist und in dem Gehäuse montiert ist und
G) einen Luftkanal (33) von dem Gebläse zu dem regelbaren Heizelement (3) und dem Infrarotheizfeld, so daß Luft mittels des Gebläses durch die Öffnungen in diesem Feld und durch das Heizelement (3) gelenkt wird.

9. Reparaturvorrichtung gemäß Anspruch 8, wobei das regelbare Heizelement (3) ein Infrarotfeld (3) ist, das Öffnungen aufweist und in der Basis und zwischen den Montageelementen montiert ist und ein Luftkanal (43) von dem Gebläse zu dem unteren Feld vorgesehen ist, so daß Luft mittels des Gebläses durch die Öffnungen in dem Feld geleitet wird, wodurch die Leiterplatte durch das untere Feld erhitzt wird, wenn eine Leiterplatte in die Befestigungen eingesetzt ist.

10. Verfahren zum Auswechseln ausgewählter Bauelemente auf einer SMT-Leiterplatte unter Verwendung einer Reparaturvorrichtung, wobei das Verfahren die Schritte umfaßt:
A) auswechselbares Befestigen einer Leiterplatte (63) in einer Montagebefestigung (7) auf einer Reparaturvorrichtung für Leiterplatten,
B) Heizen der Leiterplatte (63) und der darauf befindlichen Bauelemente durch ein erstes Heizmittel (3) auf eine beträchtlich erhöhte, vorgewählte erste Temperatur, die unter dem Schmelzpunkt von Lot liegt, das die Anschlußleitungen der Bauelemente mit der Leiterplatte (63) verbindet, und
C) Heizen der Anschlußleitungen eines ausgewählten auszuwechselnden Bauelements durch ein zweites Heizmittel (31) auf eine vorgewählte, zweite Temperatur, die Ober dem Schmelzpunkt von Lot ist, das auf den Anschlußleitungen des ausgewählten Bauelements liegt, wodurch das ausgewählte Bauelement ersetzt werden kann.

11. Verfahren gemäß Anspruch 10, wobei
A) der Leiterplatten-Heizschritt ein Aktivieren eines Infrarotfeldes (3) und ein Lenken von deionisierter Luft durch das Feld und auf die Leiterplatte, wobei die gesamte Leiterplatte auf oder nahe der ersten Temperatur gehalten wird, enthält , und
B) der Heizschritt für die Anschlußleitungen ein Aktivieren des Zweiten Heizmittels (31), ein Lenken von deionisierter Luft durch das aktivierte Heizmittel, um dadurch die Temperatur der Luft zu erhöhen und ein Lenken der Luft auf die Anschlußleitungen der ausgewählten Bauelemente enthält.

12. Verfahren gemäß Anspruch 10 oder 11, wobei es weiterhin den Schritt einschließt, das zweite Heizmittel (31) relativ zu einem ausgewählten Bauelement (63) auf der Leiterplatte durch Verschieben eines Gehäuses (21), das das zweite Heizmittel enthält, entlang eines Querstabes (23), an dem das Gehäuse positioniert ist, zu positionieren und den Stab, der eine Längsachse aufweist und an jedem Ende durch die Basis (1,25) unterstützt wird, in einer Richtung rechtwinklig zu der Längsachse zu bewegen.

13. Verfahren gemäß Anspruch 10, wobei die erste Temperatur über der Vitrifizierungstemperatur der Leiterplatte liegt.

14. Verfahren gemäß Anspruch 10, das weiterhin die Schritte umfaßt:
A) Auflegen von Lötpaste auf die Anschlußleitungen eines ausgewählten Ersatzbauelements (85),
B) Positionieren des Ersatzbauelements (85) auf der Leiterplatte (85), und
C) Unterbrechen des Heizens durch die zweiten Heizmittel, nachdem die Lötpaste schmilzt, wodurch das Lot erstarrt und das Bauelement auf der Leiterplatte befestigt wird.

15. Verfahren gemäß Anspruch 10, das weiterhin die Schritte umfaßt:
A) Unterbrechen des Heizens durch die zweiten Heizmittel (31) nachdem das Lot schmilzt, und
B) Entfernen des ausgewählten Bauelements von der Leiterplatte.

16. Verfahren gemäß Anspruch 10, das weiterhin die Schritte umfaßt:
A) Unterbrechen des Heizens der Anschlußleitungen,
B) Entfernen des ausgewählten Bauelements (85),
C) Positionieren eines neuen Bauelements (85) auf der Leiterplatte mit Lötpaste an den Anschlußleitungen,
D) Aufheizen der Anschlußleitungen des neuen Bauelements, um die Lötpaste zu schmelzen,
E) Unterbrechen des Aufheizens der Anschlußleitungen und der Leiterplatte (63), und
F) Entfernen der Leiterplatte aus der Reparaturvorrichtung.

17. Verfahren gemäß Anspruch 16, das weiterhin die Schritte umfaßt:
A) Temperaturüberwachung der Temperatur der Leiterplatte,
B) Regeln des ersten Heizelements (3), um die Leiterplatte auf erhöhter Temperatur zwischen 285 °F (141 °C) und 300 °F (149 °C) zu halten.

## Revendications

1. Station de répération pour remplacer des composants choisis (85) sur des plaquettes de circuits imprimés (63), ladite station de réparation comprenant:
A) une base (1) comportant des moyens de fixation (7) pour monter de façon amovible une plaquette de circuit SMT;
C) un premier moyen de chauffage (3, 42) disposé dans ladite base (1) pour chauffer ladite plaquette entière de circuits imprimés (63) à une première température, sensiblement élevée, au-dessous de celle qui est capable de faire fondre la soudure sur une pluralité de connexions dudit composant choisi ;
D) un second moyen de chauffage (31, 33, 39, 42) pour chauffer les connexions d'un composant choisi (85) sur ladite plaquette de circuit (63) à une seconde température qui est supérieure à ladite première température, et qui peut faire fondre la soudure sur lesdites connexions dudit composant choisi pour permettre le remplacement dudit composant ; et
E) un moyen connecté à ladite base (1) pour monter ledit second moyen de chauffage ;
F) de sorte qu'un différentiel de température inférieur peut être établi durant le chauffage entre les parties de ladite plaquette de circuit là où l'action de souder ou de défaire une soudure est en train de se faire et d'autres parties de la plaquette de circuit, de façon à réduire le dommage provenant d'une expansion thermique différentielle.

2. Station de réparation selon la revendication 1, dans laquelle lesdits moyens de montage comprennent :
A) une tige transversale (23) ayant un axe longitudinal et supportée à chaque extrémité par ladite base (1) , de façon que ladite tige soit mobile dans une direction perpendiculaire audit axe longitudinal ; et
B) un logement (21) portant ledit second moyen de chauffage (31 ou 39) et monté pour un mouvement de coulissage le long de ladite tige (23), de façon qu'un positionnement dudit second moyen de chauffage par rapport audit composant choisi (85) soit réalisé par un mouvement de ladite tige (23) et dudit logement (21).

3. Station de réparation selon la revendication 1 ou 2, dans laquelle lesdits premier et second moyens de chauffage incluent des premier et second panneaux respectifs de chauffage à rayons infrarouges (3, 31), pour diriger une énergie infrarouge vers ladite plaquette de circuit (63), et ledit premier panneau à infrarouges (3) est sensiblement plus grand que ledit second panneau à infrarouges (31).

4. Station de réparation selon la revendication 3, dans laquelle lesdits premier et second panneaux à infrarouges (3, 11) comportent des ouvertures pour diriger de l'air désionisé vers ladite plaquette de circuits imprimés (63) , et ladite station de réparation comprend , en plus, des moyens (33, 42, 43) pour diriger de l'air désionisé vers lesdits panneaux à infrarouges (3, 31).

5. Station de réparation selon la revendication 1 ou 2, dans laquelle ledit premier moyen de chauffage inclut un premier panneau à infrarouges comportant des ouvertures (3) pour chauffer un premier côté de ladite plaquette de circuits imprimés (63), et ledit second moyen de chauffage inclut un second panneau à infrarouges à ouvertures (31) , et ledit premier panneau est sensiblement plus grand que ledit second panneau (63); la station de réparation comprenant, en plus, une plaque à orifices amovible (39) positionnée au niveau de l'orifice au niveau dudit moyen de logement (42, 43) pour souffler de l'air à travers lesdites ouvertures dans ledit premier panneau pour chauffer ladite plaquette de circuit, et des moyens (42, 33, 39) pour souffler de l'air à travers ledit second panneau et une plaque à orifices pour chauffer lesdites connexions dudit composant choisi.

6. Station de réparation selon la revendication 1 ou 2, comprenant en outre un thermocouple (61) positionné dans le moyen de fixation (7) pour être en contact avec ladite plaquette de circuits imprimés (63), et un moyen (61, 64) couplé audit thermocouple pour régler la température à laquelle la plaquette de circuit est chauffée par lesdits moyens de chauffage.

7. Station de réparation selon la revendication 1, comprenant de plus :
A) une tige transversale (23) ayant un axe longitudinal et supportée sur chaque extrémité par ladite base (1), de façon à ce que ladite tige soit mobile dans une direction perpendiculaire audit axe longitudinal ;
B) un ventilateur (42) disposé dans ladite base ;
C) ledit moyen de fixation (7) supportant ladite plaquette de circuit entre ladite base et ladite tige;
D) un logement (21) positionné de façon à coulisser sur ladite tige ;
E) un panneau de chauffage à infrarouges (31) comportant des ouvertures à l'intérieur et monté dans ledit logement; et
F) un parcours d'air (33) allant dudit ventilateur audit panneau de chauffage à infrarouges pour diriger l'air issu dudit ventilateur à travers lesdites ouvertures dans ledit panneau et vers ladite plaquette de circuits, de façon à ce que ledit composant choisi puisse être chauffé par une énergie à infrarouges issue dudit panneau de chauffage et par l'air chauffé par ledit panneau de chauffage pour liquéfier la soudure sur les connexions dudit composant choisi.

8. Station de réparation pour remplacer des composants choisis sur des plaquettes de circuits SMT (63), lesdits composants (85) ayant des connexions soudées à ladite plaquette de circuit, ladite station de réparation comprenant :
A) une base (1) ayanr un élément de chauffage réglable (3);
B) une tige transversale (23) ayant un axe longitudinal et supportée sur chaque extrémité par ladite base (1, 25), de façon que ladite tige soit mobile dans une direction perpendiculaire audit axe longitudinal ;
C) un ventilateur (42) disposé dans ladite base ;
D) des fixations de montage (7) fixées à ladite base pour supporter de façon amovible ladite plaquette de circuit entre ladite base et ladite tige ;
E) un logement (21) positionné pour coulisser sur ladite tige ;
F) un panneau de chauffage à infrarouges (31) ayant des ouvertures à l'intérieur et monté dans ledit logement; et
G) un parcours d'air (33) allant dudit ventilateur audit élément de chauffage réglable (3) et audit panneau de chauffage à infrarouges , de façon que l'air soit dirigé par ledit ventilateur à travers lesdites ouvertures dans ledit panneau et à travers ledit élément de chauffage (3).

9. Station de réparation selon la revendication 8, dans laquelle ledit élément de chauffage réglable (3) est un panneau à infrarouges (3) comportant à l'intérieur des ouvertures, et monté dans ladite base et entre lesdites fixations de montage ; et
B) un parcours d'air (43) allant dudit ventilateur audit panneau inférieur, de façon que l'air soit dirigé par ledit ventilateur à travers lesdites ouvertures dans ledit panneau, de façon que, lorsqu'une plaquette est disposée dans lesdites fixations, ladite plaquette soit chauffée par ledit panneau inférieur.

10. Procédé de remplacement de composants choisis sur une plaquette de circuits imprimés SMT utilisant une station de réparation de plaquettes de circuits, ledit procédé comprenant les étapes de :
A) fixer de façon amovible une plaquette de circuits imprimés (63) dans une fixation de montage (7) sur une station de réparation de plaquette de circuits ;
B) chauffer ladite plaquette de circuits (63) et les composants qui s'y trouvent par un premier moyen de chauffage (3) à une première température présélectionnée, sensiblement élevée qui est inférieure au point de fusion de la soudure qui fixe les connexions desdits composants à la plaquette de circuits (63) ; et
C) chauffer les connexions d'un composant choisi à remplacer par un second moyen de chauffage (31) à une seconde température, pré-sélectionnée qui est supérieure à la température de fusion de la soudure disposée sur les connexions dudit composant choisi, de façon à ce que le composant choisi puisse être remplacé.

11. Procédé selon la revendication 10, dans lequel
A) ladite étape de chauffage d'une plaquette de circuits imprimés inclut d'activer un panneau à rayons infrarouges (3), et de diriger de l'air désionisé à travers ledit panneau et vers ladite plaquette de circuits, de façon que toute la plaquette de circuits soit maintenue à ladite première température ou proche de celle-ci ; et
B) ladite étape de chauffage des connexions inclut d'activer ledit second moyen de chauffage (31), de diriger l'air désionisé à travers le moyen de chauffage activé de façon à élever la température de l'air, et de diriger l'air vers les connexions des composants choisis.

12. Procédé selon la revendication 10 ou 11:
A) incluant en plus l'étape de positionner ledit second moyen de chauffage (31) par rapport à un composant choisi (63) sur ladite plaquette de circuits en faisant coulisser un logement (21) contenant ledit second moyen de chauffage le long d'une tige transversale (23) sur laquelle ledit logement est positionné et en déplaçant ladite tige ayant un axe longitudinal et supportée sur chaque extrémité par ladite base (1,25) en direction perpendiculaire audit axe longitudinal.

13. Procédé selon la revendication 10, dans lequel ladite première température est supérieure à la température de transition vitreuse de la plaquette de circuits.

14. Procédé selon larevendication 10, comprenant , de plus, les étapes de
A) disposer de la pâte à souder sur les connexions d'un composant de remplacement choisi (85);
B) positionner le composant de remplacement (85) sur ladite plaquette de circuits (85) ; et
C) interrompre le chauffage par ledit second moyen de chauffage après que la pâte à souder a fondu, de façon que la soudure se solidifie et que ledit composant soit fixé à ladite plaquette de circuits.

15. Procédé selon la revendication 10, comprenant de plus ,les étapes de
A) interrompre le chauffage par ledit second moyen de chauffage (31) après que la soudure a fondu ; et
B) enlever le composant choisi de la plaquette de circuits.

16. Procédé selon la revendication 10, comprenant de plus les étapes de :
A) interrompre le chauffage des connexions ;
B) retirer le composant choisi (85) ;
C) mettre en place un nouveau composant (85) avec de la pâte à souder sur les connexions sur ladite plaquette de circuits ;
D) chauffer les connexions du nouveau composant pour faire fondre la pâte à souder ;
E) interrompre le chauffage des connexions et de ladite plaquette de circuits (63) ; et
F) enlever ladite plaquette de circuits de ladite station de réparation.

17. Procédé selon la revendication 16, comprenant de plus les étapes de :
A) surveiller la température de la température de la plaquette de circuits ;
B) régler le premier élément de chauffage (3) pour maintenir la plaquette de circuits à la température élevée entre 141°C (285°F) et 149°C (300°F).
